# EUROPÄISCHE PATENTSCHRIFT

(11) **EP 0 946 997 B1**
(45) Veröffentlichungstag und Bekanntmachung des Hinweises auf die Patenterteilung: **05.10.2005**
(21) Anmeldenummer: 97918892.7
(22) Anmeldetag: 22.08.1997
(51) Int. Cl.: H01L 39/24, H01L 39/22

(54) **SCHICHTENFOLGE SOWIE EINE SOLCHE ENTHALTENDES BAUELEMENT**
LAYERED ARRANGEMENT AND COMPONENT CONTAINING THE LATTER
SYSTEME STRATIFIE ET COMPOSANT CONTENANT UN SYSTEME STRATIFIE DE CE TYPE

(30) Priorität: 23.08.1996 DE 19634118
(43) Veröffentlichungstag der Anmeldung: 06.10.1999
(73) Patentinhaber: FORSCHUNGSZENTRUM JÜLICH GMBH, 52425 Jülich (DE)
(72) Erfinder: FALEY, Mikhail, D-52428 Jülich (DE); POPPE, Ulrich, D-52349 Düren (DE); JIA, Chunlin, D-52428 Jülich (DE)
(86) Internationale Anmeldenummer: PCT/DE1997/001812
(87) Internationale Veröffentlichungsnummer: WO 1998/008260

(56) Entgegenhaltungen:
- EP-A- 0 345 441
- EP-A- 0 430 798
- US-A- 5 508 255
- FALEY M I ET AL: "Josephson junctions, interconnects, and crossovers on chemically etched edges of YBa/sub 2/Cu/sub 3/O/sub 7-x/" APPLIED PHYSICS LETTERS, 11 OCT. 1993, USA, Bd. 63, Nr. 15, ISSN 0003-6951, Seiten 2138-2140, XP000397835 in der Anmeldung erwähnt

## Beschreibung

Die Erfindung betrifft eine Schichtenfolge gemäß dem Oberbegriff des Anspruchs 1. Desweiteren betrifft die Erfindung ein kryogenes Bauelement gemäß dem Oberbegriff des Anspruchs 11.

Die Anwendung von Hochtemperatursupraleitern für den Einsatz in kryoelektronischen Bauelementen benötigt die Entwicklung integrierter Mehrlagenschaltkreisen. Beispiele für supraleitende, integrierte Mehrlagenschaltkreise sind SNS-Josephson-Kontakte oder Flußtransformatoren. Außerdem werden zur Herstellung beispielsweise eines Flußtransformators oftmals Durchkontaktierungen oder Leiterbahnüberkreuzungen gebraucht.

Josephson-Kontakte, Durchkontaktierungen und Leiterbahnüberkreuzungen sind außerdem Hauptkomponenten für eine Reihe weiterer Multilagenbauelemente und im übrigen bedeutsam für die Kryoelektronik im allgemeinen.

Die Eigenschaften solcher Bauelemente in Schichttechnik, wie zum Beispiel die Josephson-Kontakte, sollen bezüglich der Barriere zwischen den supraleitenden Kontakten durch das Barrierenmaterial und nicht durch den Grenzflächenwiderstand der Grenzflächenbereiche zwischen den sich berührenden Schichten bestimmt sein.

Zur erwünschten Unterdrückung von Grenzflächenwiderständen in solchen Kontakten werden saubere ex-situ hergestellte Grenzflächen von Hochtemperatursupraleiter-Materialien wie YBa₂Cu₃O₇₋ₓ oder PrBa₂Cu₃O₇₋ₓ beispielsweise durch chemisches Ätzen in nichtwässiger Br-Ethanol Lösung präpariert [M.I.Faley, U.Poppe, H.Soltner, C.L.Jia, M.Siegel, and K.Urban, "Josephson junctions, interconnects and crossovers on chemically etched edges of YBa₂Cu₃O₇ ". - Appl.Phys.Lett., v.63, No.15, 2138-2140 (1993)].

Das chemische Ätzen produziert dabei nicht nur strukturell ungeschädigte Grenzflächen sondern auch kleine Kantenwinkel von etwa 3°. Die Nützung dieser flachen Kanten nach der Strukturierung der Hochtemperatursupraleiter-Dünnfilme ist aus zwei Gründen bedeutsam: einerseits trägt solche Kantenstruktur zur Lösung des Problems eines Stromtransportes in c-Richtung bei den stark anisotropen Hochtemperatursupraleitern bei. Andererseits erlaubt es eine relative homogene Bedeckung der Grundelektrode durch eine isolierende bzw. nichtsupraleitende Schicht.

Die homogene Bedeckung der Grundelektrode durch eine dünne Barrierenschicht ist ebenfalls bei der Herstellung von Josephson-Kontakten von Bedeutung. Ideale Durchkontaktierungen (vias) sollten möglichst keinen Grenzflächenwiderstand aufweisen, während demgegenüber zur Herstellung von Leiterbahnüberkreuzungen gute isolierende Eigenschaften notwendig sind. Zur Zeit werden zur Isolation oft kubische Materialien wie zum Beispiel SrTiO₃ oder CeO₂ benutzt. Diese Materialien weisen jedoch den Nachteil auf, daß die supraleitende Grundelektrode oft defizient an Sauerstoff ist und keine ausreichenden supraleitenden Eigenschaften besitzt. Zudem nachteilig ist, daß die vorteilhafte nichtwäßrige, chemische Ätzung in Br-Ethanol für Leiterbahnüberkreuzungen oder Josephson-Kontakte nicht zum Einsatz kommen kann.

Es ist deshalb Aufgabe der Erfindung eine Schichtenfolge zu schaffen, bei dem die Qualität der Grenzflächenbereiche zwischen den Schichten in Abhängigkeit der erwünschten Randbedingungen gezielt einstellbar ist.

Die Aufgabe wird gelöst durch eine Schichtenfolge gemäß der Gesamtheit der Merkmale nach Anspruch 1. Die Aufgabe wird ferner gelöst durch ein kryogenes Bauelement gemäß der Gesamtheit der Merkmale nach Anspruch 11. Weitere zweckmäßige oder vorteilhafte Ausführungsformen oder Varianten finden sich in den auf jeweils einen dieser Ansprüche rückbezogenen Unteransprüchen.

Es wurde erkannt, gemäß Anspruch 1 zwischen den beiden Schichten eine modifizierte Grenzflächenschicht vorzusehen. Gemäß Anspruch 2 kann der modifizierte Grenzflächenbereich zur Schaffung isolierender Bereiche dienen. Zur Modifikation kann vorteilhafterweise gemäß Anspruch 3 eine Dotierung mit Metallionen oder gemäß Anspruch 4 eine Implantation vorgesehen sein.

Es wurde erkannt, auf diese Weise eine Möglichkeit zu finden, ein epitaktisches Multilagensystem mit Hochtemperatursupraleitern für integrierte kryoelektronische Schaltungen herzustellen, welches insbesondere zur Herstellung von Josephson-Kontakten, Durchkontaktierungen oder Leiterbahnüberkreuzungen geeignet ist. Es werden gegenüber bisher bekannten, vergleichbaren Strukturen in vorteilhafter Weise verbesserte supraleitende Eigenschaften innerhalb der gesamten Heterostruktur erhalten.

Die erfindungsgemäße Schichtenfolge bzw. das erfindungsgemäße Bauelement weist ein homogenes epitaktisches Wachstum und eine vollständige Oxidation der Schichtenfolge, insbesondere der Multilagenstruktur auf. Diese Anforderungen sind beim Einsatz von oxidischen Materialien erfüllt, welche technologisch, chemisch und strukturell miteinander verträglich sind.

Es wurde erkannt, daß die oxidischen Hochtemperatursupraleiter grundsätzlich eine Ladungsträgerdichte haben, die mit denen stark dotierter Halbleiter vergleichbar ist. Die räumliche Variation der Ladungsträgerdichte beispielsweise an Grenzflächen kann daher im Vergleich zu gewöhnlichen Metallen auf relativ großen Distanzen bis zu etwa 100 nm in die Schicht hinein erfolgen. Daher werden die Transporteigenschaften von dünnen oxidischen Materialien stark vom Verhalten im Bereich der Grenzflächen zwischen den jeweiligen Schichten beeinflußt.

Mit Hilfe der Modifikation einer oder mehrerer dieser Grenzflächen und damit die Einstellbarkeit des Wertes des Grenzflächenwiderstandes in einem großen Wertebereich kann man integrierte Multilagensysteme auf der Basis von Hochtemperatursupraleitern herstellen, welche die individuell auf ihre Funktion abzustimmenden Anforderungen an solche Kryoelektronischen Bauelemente erfüllen.

Eine gezielte Veränderung oder Einstellbarkeit des Grenzflächenwiderstandes wird durch eine gezielte Manipulation der Grenzflächen auf diese Weise erzielt. Dabei können unterschiedliche Materialien, welche technologisch, chemisch und strukturell miteinander verträglich sind, zum Einsatz kommen.

Die Erfindung ist im weiteren an Hand von Figuren und Ausführungsbeispiel näher erläutert. Es zeigt:
- Fig. 1:: Hochauflösende transmissionselektronmikroskopische Aufname einer Zwischenschicht an der Grenzfläche der erfindungsgemäßen Schichtenfolge, welche auf Ionenstrahlätzung der PrBa₂Cu₃O₇₋ₓ-Schicht zurückführbar ist;
- Fig. 2:: spezifischer Widerstand entlang der c-Achse für 0,5 µm dicke PrBa₂Cu₃O₇₋ₓ "isolations"- Schichten, welche zwischen zwei YBa₂Cu₃O₇₋ₓ -Elektroden angeordnet sind;
- Fig. 3:: Seitlicher Ansicht eines erfindungsgemäßen Josephsonkontaktes mit modifizierten Grenzflächenbereichen.

### Ausführungsbeispiel

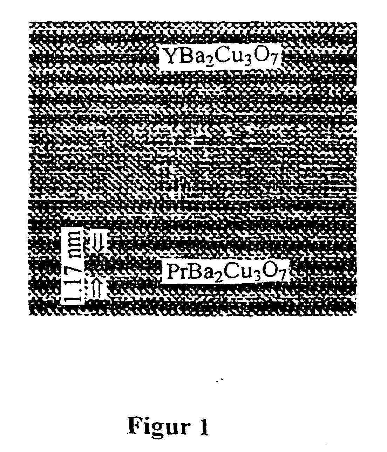

In der Figur 1 ist eine TEM-Aufnahme einer erfindungsgemäßen Schichtenfolge gezeigt. Erkennbar ist dabei eine modifizierte Zwischenschicht an der Grenzfläche zwischen der supraleitenden und der nicht-supraleitenden Schicht der erfindungsgemäßen Schichtenfolge. Diese Zwischenschicht wurde mittels einer Ionenstrahlätzung der nicht-supraleitende PrBa₂Cu₃O₇₋ₓ-Schicht vor Bildung der auf dieser Schicht aufgebrachter supraleitenden Schicht erhalten.

Dabei wurde eine saubere, ungestörte Grenzflächen vor der Modifikation der nicht-supraleitenden freien Schichtoberfläche durch den Gebrauch einer chemischen Ätzung in Br-Ethanol in Verbindung mit einer Photolithographie mittels harter UV-Strahlung in bekannter Weise erhalten.

Strukturell modifizierte bezw. geschädigte Grenzflächen wurden sodann durch den Beschuß der Oberfläche der oxidische Materialien mit einem Ionenstrahl insbesondere mit einer Energie von 600 eV hergestellt. Über eine Variation der Bestrahlungszeit bezw. der Ionenenergie lassen sich je nach erwünschter Randbedingung der Modifikation unterschiedlich starke Schädigungen an der Grenzfläche erzielen. Im Falle von epitaktischen Heterostrukturen des Hochtemperatursupraleiters YBa₂Cu₃O₇₋ₓ in Verbindung mit halbleitenden PrBa₂Cu₃O₇₋ₓ Dünnfilmen lassen sich beispielweise durch Kombination des chemischen Ätzens mit Ionenstrahlätzen Grenzflächenwiderstände RₙA im Bereich von RₙA ≈ 100 Ω·cm² bis zu weniger als 1*10⁻¹⁰ Ω·cm² realisieren. Dabei ist der Wert A die Größe der Kontaktoberfläche.

Unterschiedliche und insbesondere hohe Werte für den Grenzflächenwiderstand können alternativ oder kommulativ durch verschiedene Modifikationen bzw. Manipulationen der Grenzfläche des Materials in einem dünnen Schichtoberflächenbereich, vorzugsweise bis zu 10nm, an der Grenzfläche, beispielsweise durch Dotierung unterschiedlicher Metallionen oder partieller Substitution des Sauerstoffs zum Beispiel mit F, Br, Cl, erzielt werden.

Ein wichtige Erkenntnis war, daß bei dieser Grenzflächenmodifikation eine dünne epitaktische Zwischenschicht an der Grenzfläche erhalten wird, welche einen hohen Grenzflächenwiderstand bilden kann. Dieser Grenzflächenwiderstand beeinflußt dabei auch die Ladungsträgerdichte in Elektrodenmaterialien, insbesondere die Transporteigenschaft von YBa₂Cu₃O₇₋ₓ bzw. PrBa₂Cu₃O₇₋ₓ in der Nähe (bis zu 100 nm) der Grenzfläche der hier beispielhaft aufgeführten, erfindungsgemäßen Schichtenfolge.

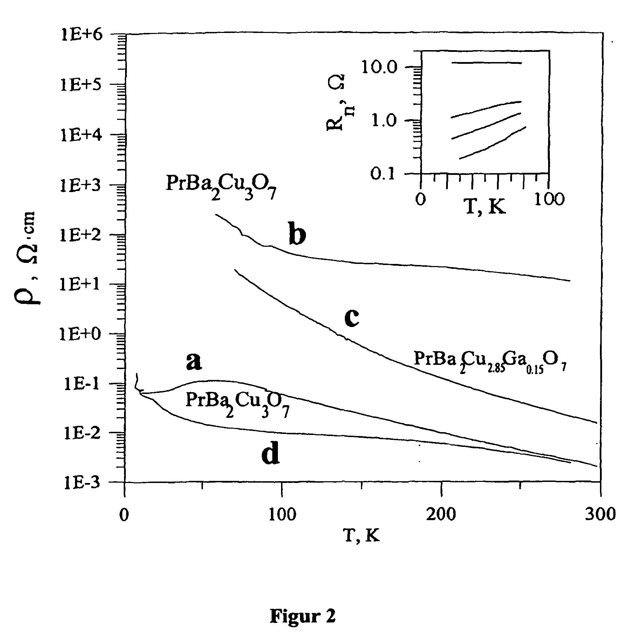

In der Figur 2 ist der spezifische Widerstand entlang der c-Achse für 0,5 µm dicke PrBa₂Cu₃O₇₋ₓ "isolations"-Schichten, zwischen zwei YBa₂Cu₃O₇₋ₓ-Elektroden angeordnet, dargestellt.

Dabei sind die Meßwerte für die rein chemisch geätzte Grenzflächen durch die Kurve "a" und durch Ionenstrahlätzung geschädigte Grenzflächen durch "b" dargestellt. Die Kurven "c" und "d" zeigen den spezifischen Widerstand von PrBa₂Cu_{2.85}Ga_{0.15}O₇₋ₓ- und PrBa₂Cu₃O₇₋ₓ-Filmen entlang der ab-Ebenen dieser Materialien. Der Einsatz in der genannten Figur zeigt die Temperaturabhängigkeit vom Josephsonkontaktwiderstand Rₙ(T) für Kontakte mit Barrierendicken von 10 nm, 20, nm, 30 nm und 100 nm (von unten nach oben dargestellt).

Die Modifikation des Grenzflächenwiderstandes an der Grenzfläche zwischen der YBa₂Cu₃O₇₋ₓ-Schicht und der PrBa₂Cu₃O₇₋ₓ-Schicht durch Argon-Ionenätzen ermöglichte es den Isolationwiderstand der PrBa₂Cu₃O₇₋ₓ-Isolationsschicht um bis zu vier Größenordnungen zu erhöhen bzw. einzustellen (siehe Figur 2) Auf diese Weise konnten Multilagenflußtransformatoren hoher Qualität hergestellt werden.

Eine PrBa₂Cu₃O₇₋ₓ-Schicht zwischen zwei YBa₂Cu₃O₇₋ₓ-Elektroden mit ungeschädigten Grenzflächen zeigt im Vergleich zu Massivproben einen sehr kleinen spezifischen Widerstand (Einsatz in Figur 2). Dies ist vorteilhaft für Josephson-Kontakte, weil man auf diese Weise relativ große (>10nm) Barrierendicken benutzen kann, welche größer als typische Oberflächenrauhigkeiten sind und man damit im Ergebnis eine homogene Stromdichteverteilung im Josephson-Kontakt erzielt.

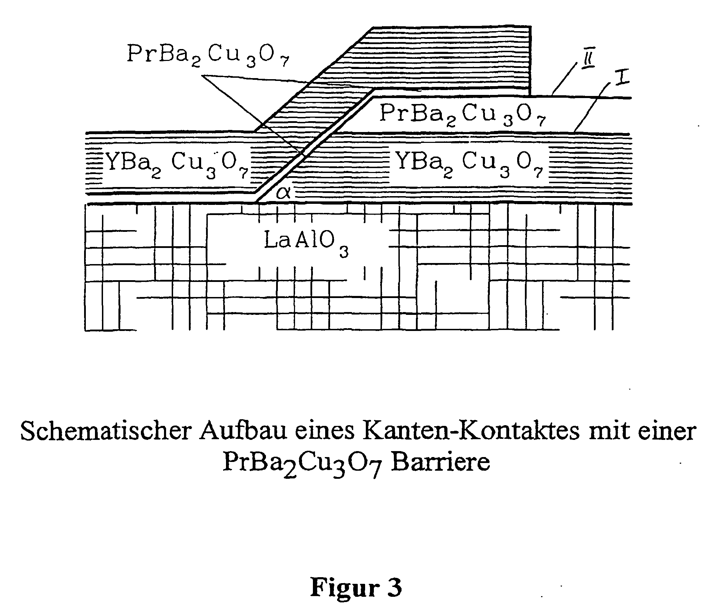

In der Figur 3 ist in seitlicher Ansicht ein erfindungsgemäßer Josephsonkontakt mit modifizierten Grenzflächenbereichen gezeigt. Dazu ist auf einem Substrat aus LaAlO₃ eine erste supraleitende Elektrode aus YBa₂Cu₃O₇ gebildet. Die freie Oberfläche I wurde sodann gesäubert und modifiziert um einen hohen Grenzflächenwiderstand zu bilden. Darauf aufgebracht wurde sodann eine nicht-supraleitenden Schicht aus PrBa₂Cu₃O₇ deren freien Oberfläche II aus gleichem Grunde ebenfalls modifiziert wurde.

Sodann wurde chemisch unter einem Winkel α von 3° eine Schräge geätzt und die freie Substratoberfläche, die Schräge sowie die freie Oberfläche II der nicht-supraleitenden Schicht mit einer dünnen (10-100nm) Schicht aus nicht-supraleitendem PrBa₂Cu₃O₇ überdeckt. Schließlich wurde eine weitere supraleitende Schicht aus YBa₂Cu₃O₇, vorzugsweise mit einer Schichtdicke im Bereich von 100-300nm, gebildet. An der Schräge im Bereich zwischen beiden supraleitenden Schichten ist im Ergebnis sodann ein Josephsonkontakt ausgebildet. Die Modifikationen an den Grenzflächenbereichen I und II bewirken ein Bauelement mit verbesserter elektronischer Eigenschaft, da sie eine bessere elektrische Isolierung bewirkt in dem Bereich des Bauelements, wo ein Stromfluß unterbleiben soll. Die erfindungsgemäße Meßdaten der Figur 2 gehen auf einen solchen erfindungsgemäßen Kontakt zurück.

Die eine epitaktische Heterostruktur enthaltende Schichtenfolge enthält mindestens eine Grenzfläche zwischen einem oxidischen Supraleiter.und einem nichtsunichtsupraleitenden Oxid (oder einem oxidischen Supraleiter mit einer niedrigeren Sprungtemperatur). Durch mehrfachen Aufbau einer solchen Schichtenfolge kann ein Multilagensystem erhalten werden.

Das supraleitende Oxidmaterial ist charakterisiert durch eine Lagenstruktur, welche wenigstens Sauerstoff und Cu enthält und eine Ladungsträgerdichte zwischen 1*10¹⁸ und 5*10²¹ cm⁻³ aufweist. Die nicht supraleitende oxidische Schicht ist charakterisiert durch eine Kompatibilität mit der supraleitenden Schicht hinsichtlich der Technologie, Chemie und Struktur und sollte vorzugsweise eine Ladungsträgerdichte zwischen 1*10¹⁸ und 5*10²¹ cm⁻³ besitzen.

Die durch Ionenbestrahlung erhaltene Modifikation der Grenzfläche in einer dünnen (<10nm) Schicht in der Nähe der Grenzfläche kann sowohl struktureller als auch chemischer (z.B.Dotierung) oder anderer Natur sein. Es kann beispielsweise auch eine sehr dünne (<10 nm) Zwischenlage eines anderen Materials sein. Entscheidend ist, das eine gezielte Manipulation des Grenzflächenwiderstandes die Transporteigenschaften der angrenzenden Materialien beeinflußt.

Im übrigen ist es empfehlenswert, eine Schichtoberfläche mit Hilfe einer bekannten Methode zunächst zu saubern und sodann die Modifikation durch Behandlung ihrer Oberfläche oder Aufbringen einer modifizierten weiteren Schicht vorzunehmen, wenn diese Verfahrensweise auch nicht zwingend ist.

## Patentansprüche

1. Schichtenfolge, enthaltend wenigstens eine Schicht auf der Basis eines hochtemperatursupraleitenden Materials mit wenigstens eine CuO₂-Ebene aufweisender Einheitszelle, eine mit dieser Schicht verbundene, nicht-supraleitende oxidische Schicht, **gekennzeichnet durch**,
eine Ausbildung der Grenzfläche als Grenzflächenschicht zwischen der hochtemperatursupraleitenden und der nicht-supraleitenden Schicht mit einer **durch** Ionenbestrahlung wenigstens einer der beiden Schichten erhaltenen geschädigten Struktur.

2. Schichtenfolge nach Anspruch 1 zur Bildung eines Josephson-Kontakts,
**gekennzeichnet durch**,
eine Grenzflächenschicht mit einer **durch** Ionenbestrahlung erhaltenen geschädigten Struktur, die auf den Bereich beschränkt ist, der nicht zum Stromfluß vorgesehen ist.

3. Schichtenfolge nach Anspruch 1 oder 2, **dadurch gekennzeichnet, daß** der Oberflächenbereich oder die Grenzflächenschicht zur Modifikation mit Ionen, insbesondere mit Metallionen, dotiert ist.

4. Schichtenfolge nach Anspruch 1 oder 2, **dadurch gekennzeichnet, daß** der Oberflächenbereich oder die Grenzflächenschicht zur Modifikation mit Ionen, insbesondere mit Metallionen, implantiert ist.

5. Schichtenfolge nach einem der Ansprüche 1 bis 4, **dadurch gekennzeichnet, daß** die nicht-supraleitende Schicht an der von der supraleitenden Schicht abgewandten Oberfläche ebenfalls im Oberflächenbereich modifiziert ist.

6. Schichtenfolge nach einem der Ansprüche 1 bis 5, **dadurch gekennzeichnet, daß** die nicht-supraleitende Schicht an der von der supraleitenden Schicht abgewandten Oberfläche mit einer weiteren hochtemperatursupraleitenden Schicht verbunden ist.

7. Schichtenfolge nach einem der vorhergehenden Ansprüche, **gekennzeichnet durch** PrBa₂Cu₃O₇₋ₓ als Material für die nicht-supraleitende Schicht.

8. Multilagensystem mit mehreren Schichtenfolgen nach einem der vorhergehenden Ansprüche.

9. Als Durchkontaktierung ausgebildetes Multilagensystem nach Anspruch 8.

10. Als Leiterbahnüberkreuzung ausgebildetes Multilagensystem nach Anspruch 8.

11. Kryogenes Bauelement mit wenigstens einer Schichtenfolge nach einem der Ansprüche 1 bis 7.

12. Kryogenes Bauelement mit wenigstens einem Multilagensystem nach Anspruch 8.

13. Josephsonkontakt als kryogenes Bauelement nach Anspruch 11 oder 12.

14. Flußtransformator als kryogenes Bauelement nach Anspruch 11 oder 12.

## Claims

1. Layered arrangement containing at least one layer based on a high-temperature superconducting material with at least one unit cell having a CuO₂ plane and a non-superconducting oxidic layer bonded to said layer,
**characterized by**
a formation of the interface as an interface layer between the high-temperature superconducting and the non-superconducting layers with a damaged structure obtained by ion irradiation of at least one of the two layers.

2. Layered arrangement according to Claim 1 for the formation of a Josephson contact,
**characterized by**
an interface layer with a damaged structure obtained by ion irradiation, which is limited to the region not envisaged for current conduction.

3. Layered arrangement according to Claim 1 or 2, **characterized in that** the surface region or interface layer is doped with ions, particularly metal ions, for modification.

4. Layered arrangement according to Claim 1 or 2, **characterized in that** the surface region or interface layer is implanted with ions, particularly metal ions, for modification.

5. Layered arrangement according to one of Claims 1 to 4, **characterized in that** the non-superconducting layer on the surface facing away from the superconducting layer is also modified in the surface region.

6. Layered arrangement according to one of Claims 1 to 5, **characterized in that** the non-superconducting layer on the surface facing away from the superconducting layer is bonded to a further high-temperature superconducting layer.

7. Layered arrangement according to one of the foregoing claims, **characterized by** PrBa₂Cu₃O₇₋ₓ as the material for the non-superconducting layer.

8. Multi-layer system with several layered arrangements according to one of the foregoing claims.

9. Multi-layer system according to Claim 8 in the form of a through connection.

10. Multi-layer system according to Claim 8 in the form of a strip conductor crossover.

11. Cryogenic component with at least one layered arrangement according to one of Claims 1 to 7.

12. Cryogenic component with at least one multi-layer system according to Claim 8.

13. Josephson contact as a cryogenic component according to Claim 11 or 12.

14. Flow transformer as a cryogenic component according to Claim 11 or 12.

## Revendications

1. Système stratifié comprenant au moins une couche à base d'un matériau supraconducteur à haute température avec une maille élémentaire présentant au moins un plan CuO₂, une couche oxydique non supraconductrice reliée à cette couche, **caractérisé par**
une configuration de l'interface en tant que couche d'interface entre la couche supraconductrice à haute température et la couche non supraconductrice, ayant une structure détériorée obtenue par irradiation par ions d'au moins une des deux couches.

2. Système stratifié selon la revendication 1, pour former un contact de Josephson, **caractérisé par** une couche d'interface ayant une structure détériorée obtenue par irradiation par ions, qui est limitée à la zone qui n'est pas prévue pour le passage du courant.

3. Système stratifié selon la revendication 1 ou 2, **caractérisé en ce que** la zone de la surface ou la couche d'interface est dopée par modification avec des ions, en particulier des ions métalliques.

4. Système stratifié selon la revendication 1 ou 2, **caractérisé en ce que** la zone de la surface ou la couche d'interface est implantée par modification avec des ions, en particulier des ions métalliques.

5. Système stratifié selon l'une des revendications 1 à 4, **caractérisé en ce que** la couche non supraconductrice est également modifiée en surface sur la face opposée à la couche supraconductrice.

6. Système stratifié selon l'une des revendications 1 à 5, **caractérisé en ce que** la couche non supraconductrice est reliée à une autre couche supraconductrice à haute température sur la face opposée à la couche supraconductrice.

7. Système stratifié selon l'une des revendications précédentes, **caractérisé par** PrBa₂Cu₃O₇₋ₓ comme matériau pour la couche non supraconductrice.

8. Système multicouche ayant plusieurs systèmes stratifiés selon l'une des revendications précédentes.

9. Système multicouche selon la revendication 8 en tant que contact traversant.

10. Système multicouche selon la revendication 8 en tant que croisement des pistes conductrices.

11. Elément cryogènique avec au moins un système stratifié selon l'une des revendications 1 à 7.

12. Elément cryogènique avec au moins un système multicouche selon la revendication 8.

13. Contact de Josephson en tant qu'élément cryogènique selon la revendication 11 ou 12.

14. Transformateur de flux en tant qu'élément cryogènique selon la revendication 11 ou 12.
